Europäisches Patentamt

European Patent Office

Office européen des brevets

(11) Veröffentlichungsnummer: **0 252 410 B1**

# (12) EUROPÄISCHE PATENTSCHRIFT

(45) Veröffentlichungstag der Patentschrift: **21.08.91**

(21) Anmeldenummer: **87109366.2**

(22) Anmeldetag: **30.06.87**

(51) Int. Cl.⁵: **B32B 29/04**, B32B 5/16,
B32B 3/20, B32B 27/18,
//B41M5/00,H05K3/10,
H01B1/12,B01J13/02

(54) Verwendung von Pyrrol enthaltenden Mikrokapseln.

(30) Priorität: **11.07.86 DE 3623413**

(43) Veröffentlichungstag der Anmeldung:
**13.01.88 Patentblatt 88/02**

(45) Bekanntmachung des Hinweises auf die
Patenterteilung:
**21.08.91 Patentblatt 91/34**

(84) Benannte Vertragsstaaten:
**DE FR GB**

(56) Entgegenhaltungen:
**EP-A- 0 000 903**
**DE-B- 1 267 961**
**GB-A- 2 134 125**

(73) Patentinhaber: **BASF Aktiengesellschaft**
**Carl-Bosch-Strasse 38**
**W-6700 Ludwigshafen(DE)**

(72) Erfinder: **Naarmann, Herbert, Dr.**
**Haardtblick 15**
**W-6719 Wattenheim(DE)**
Erfinder: **Sliwka, Wolfgang, Dr.**
**Diemstrasse 8**
**W-6940 Weinheim(DE)**

## Beschreibung

Die Erfindung betrifft die Verwendung von Gemischen von Mikrokapseln, deren jeweils eine Sorte Pyrrol und deren andere Sorte ein Oxidationsmittel enthält, zur Herstellung von aus Polypyrrol bestehenden elektrisch leitfähigen Mustern auf elektrisch nichtleitenden Werkstoffen.

Verbundschichtstoffe aus einer nichtleitenden Schicht und elektrischen Leitern sind bekannt. Sie werden beispielsweise durch Vakuumbedampfung von Metallen, wie Kupfer oder Silber auf Flächengebilden aus Isolierstoffen hergestellt.

Die EP-A-0 131 914 beschreibt ein Verfahren zur Herstellung von elektrisch leitfähigen Pyrrol-Polymeren, bei dem man Verbindungen aus der Klasse der Pyrrole in Gegenwart von Leitsalzen mit Sauerstoff enthaltenden Oxidationsmitteln behandelt, so daß ein Polypyrrol entsteht, das Leitsalzanionen eingebaut enthält und somit elektrisch leitfähig ist. Aus solchen elektrisch leitfähigen Polymeren, die meist in feinteiliger Form erhalten werden, können durch Verpressen unter Druck bei höheren Temperaturen Formkörper hergestellt werden, die beispielsweise als Elektroden in Batterien oder als elektrische Leiter oder als Abschirmstoffe dienen können.

Die GB-A-134 125 beschreibt ausschließlich die elektrochemische Polymerisation von Pyrrol und die Anwendung der erhaltenen Polypyrrole in elektrochemischen Zellen. Die Herstellung von Reaktionsdurchschreibepapier wird z.B. in der EP-AZ-000 903 beschrieben; die angegebenen Systeme enthalten den Farbstoffbildner in einen hydrophoben System, das sich für die nachstehend beschriebene Erfindung nicht eignet.

Aufgabe der Erfindung ist die Herstellung von elektrisch leitfähigen Polymerisaten in Form von elektrischen Leitungsmustern auf elektrisch nichtleitenden Werkstoffen.

Die Aufgabe der Erfindung wird durch die Verwendung von Gemischen von Mikrokapseln gelöst, deren jeweils eine Sorte im wesentlichen Pyrrol und deren andere Sorte im wesentlichen ein Oxidationsmittel aus der Klasse der Salze von Peroxosäuren oder von Perchlorsäure, d.h. deren Anion enthält, wobei mindestens eine Sorte ferner ein Leitsalz enthält aus der Gruppe der Salze mit den Anionen $BF_4^-$, $AsF_4^-$, $R\text{-}SO_3^-$, $AsF_6^-$, $SbF_6^-$, $SbCl_6^-$, $ClO_4^-$ und $SO_4^{2-}$ zur Herstellung von Schaltungsnetzen oder Informationsträgern durch Ausübung von Druck in Form eines Musters oder einer Druckspur auf eine auf einen elektrisch nichtleitenden Werkstoff aufgebrachte Schicht des Gemisches der Mikrokapseln, wobei elektrisch leitfähiges Polypyrrol in der Anordnung des Druckmusters bzw. der Druckspur gebildet wird.

Die Schicht aus dem nicht leitenden Werkstoff ist meist flächig ausgebildet. Sie kann in Form von Bahnen oder auch Bändern vorliegen. Es ist aber auch möglich, diese Schicht gewölbt oder in beliebiger Form zu gestalten. Der nicht leitende Werkstoff kann beispielsweise ein Kunststoff sein, so z.B. ein thermoplastischer Kunststoff wie Polyvinylchlorid, Polystyrol, Polyethylen.

Der Werkstoff kann aber auch auf der Grundlage von Zellstoff aufgebaut sein, wie Papier, oder Cellulosederivat.

Für bestimmte Anwendungen, auf die später eingegangen wird, ist es beispielsweise zweckmäßig, die nicht leitende Schicht in einem Bereich der Dicke von 0,001 bis 0,1 mm zu halten.

Auf die Schicht aus dem nicht leitenden Werkstoff wird eine Schicht aus einem Gemisch von Microkapseln aufgebracht. Ein Anteil der Microkapseln enthält Pyrrol und ein anderer Teil der Microkapseln ein Oxidationsmittel. Mindestens eine Sorte der Microkapseln enthält außerdem ein Leitsalz.

In den Kapseln kann außer Pyrrol noch ein Lösungsmittel enthalten sein. Es können organische Lösungsmittel, wie Dimethylsulfoxid, Methanol, Acetonitril oder Propylencarbonat sein. Es kann aber auch eine Mischung aus Wasser und mit Wasser mischbaren Lösungsmitteln, wie Dioxan oder Tetrahydrofuran verwendet werden. Man arbeitet zweckmäßig mit Lösungen, die 1 bis 50, vorzugsweise 5 bis 20 Gew.-% Pyrrol im Gemisch mit dem Lösungsmittel enthalten.

Als Leitsalze dienen ionische oder ionisierbare Verbindungen. Als Kationen für diese Leitsalze kommen neben den Erdalkalimetall-Kationen und $H^+$, insbesondere die Alkalimetall-Kationen, vorzugsweise $Li^+$, $Na^+$ oder $K^+$, in Betracht. Sehr günstig sind die Onium-Kationen, vor allem des Stickstoffs und des Phosphors, etwa des Typs $R_4N^+$ und $R_4P^+$, worin R Wasserstoff und/oder niedere Alkylreste, vorzugsweise mit 1 bis 6 C-Atomen, cycloaliphatische Reste, vorzugsweise mit 6 bis 14 C-Atomen, oder aromatische Reste, vorzugsweise mit 6 bis 14 C-Atomen, bedeutet. Unter den Ammonium- und Phosphonium-Kationen sind diejenigen besonders bevorzugt, in denen R Wasserstoff und/oder einen Alkylrest mit 1 bis 4 C-Atomen darstellt. Beispielhaft für bevorzugte Onium-Kationen seien neben dem $NH_4^+$-Ion insbesondere das Tetramethylammonium-, das Tetraethylammonium-, das Tetra-n-butylammonium-, das Triphenylphosphonium- und das Tri-n-butylphosphonium-Kation genannt.

Als Anionen für das Leitsalz werden $BF_4^-$, $AsF_4^-$, $R\text{-}SO_3^-$, $AsF_6^-$, $Sb_6F_6^-$, $ClO_4^-$, $HSO_4^-$ und $SO_4^{2-}$ verwendet. Die Leitsalzkonzentration beträgt im allgemeinen 0,001 bis 1, vorzugsweise 0,01 bis 0,1 Mol/Liter.

Die Leitsalze können in den Kapseln enthalten sein, die das Pyrrol enthalten. Man kann sie aber auch den Kapseln, die das Oxidationsmittel enthalten, zusetzen. Es ist auch möglich, daß beide Kapselanteile das Leitsalz enthalten.

Ein anderer Kapselanteil enthält ein Oxidationsmittel. Dieses Oxidationsmittel liegt vorteilhaft in Form einer Lösung vor. Zweckmäßig verwendet man auf 1 Mol Pyrrol 0,2 bis 10 Mol des Oxidationsmittels. Verwendet man weniger als 0,2 Mol, so kann man feststellen, daß ein Teil der verwendeten Ausgangssubstanz nicht zu Polymeren umgewandelt wird. Größere Mengen als 10 Mol an Oxidationsmitteln zu verwenden, ist meist nicht erforderlich, da die Menge ausreicht, die gesamte Menge an Pyrrol in Polymere umzuwandeln. Von den Sauerstoff enthaltenden Oxidationsmitteln haben sich besonders Peroxosäuren und deren Salze, die Peroxodischwefelsäure und deren Alkali- und Ammoniumsalze bewährt. Als Lösungsmittel für das Oxidationsmittel eignet sich z.B. Wasser gegebenenfalls mit Zusatz von Alkoholen.

Man arbeitet zweckmäßig mit Lösungen der Oxidationsmittel, die 1.. bis 15 % des Oxidationsmittels enthalten.

Die Microkapseln, die auf den nichtleitenden Werkstoff aufgebracht werden, werden als Gemisch aufgebracht. Am zweckmäßigsten ist es, falls die oben angegebenen Prozentsätze eingehalten werden, die Kapselanteile im Verhältnis von etwa 1 : 1 zu mischen. Die Kapselgröße der Microkapseln liegt im Bereich von 0,1 $\mu$ bis 10 $\mu$. Man bringt die Kapselgemische in einer Schichtdicke auf, die zwischen 0,01 und 0,5 cm liegt.

Das Entkapsulieren von Lösungen und Feststoffen ist bekannt. So findet man beispielsweise Angaben über Microkapseln und deren Herstellung im Kirk-Orthmer "Encyclopädia of Chemical Technology, 3. Ausgabe, Vol. 15, Seite 470 - 493. Weitere Angaben können aus Römp Chemielexikon, 7. Auflage, Band 4, Seite 2169, entnommen werden. Nach einer weiteren Ausbildung der Erfindung ist es zweckmäßig, auf die Schicht des nichtleitenden Werkstoffs eine Schicht des Gemisches der Microkapseln und darauf wiederum eine Schicht eines nichtleitenden Werkstoffs aufzubringen. Die beiden Schichten von nichtleitenden Werkstoffen können aus den gleichen oder unterschiedlichen Werkstoffen bestehen.

Die erfindungsgemäßen Verbundschichtstoffe können nun so behandelt werden, daß sich die entkapsulierten Anteile mischen und so ein elektrisch leitfähiges Polymeres bilden. Die Behandlung erfolgt zweckmäßig unter Druck, so daß die Kapseln platzen. So kann man z.B. durch Überführen eines Stiftes unter Druck über entkapsulierte Schicht einen elektrischen Leiter auf den isolierenden Untergrund erzeugen. Es ist aber auch möglich den Druckimpuls durch kontinuierliches Führen als Teststreifen durchzuführen.

Die erfindungsgemäßen Schichtstoffe können verschiedenen Verwendungen zugeführt werden. Sie eignen sich z.B. als Informationsträger, zur Herstellung von Schaltungsnetzen oder als Element in Lernspielen.

Die Erfindung ist des weiteren in den folgenden Beispielen erläutert.

## Beispiel 1

1. Die Kapselteilchen haben einen Durchmesser von 0,1 mm und eine Hülle aus einem Gemisch aus Polystyrol und Polybutylacrylat im Verhältnis 30:70 Gew.-%. Die Dicke der Hülle der Kapselteilchen beträgt 0,005 mm. Die Kapselteilchen sind mit einer 50 %igen Lösung von Pyrrol in Ethanol gefüllt.
2. Kapselteilchen gleicher Zusammensetzung und gleicher Größe sind mit einer 5 %igen Lösung von Eisen-III-Perchlorat gefüllt.

Die Kapselteilchen nach 1 und nach 2 werden im Verhältnis von 1:3 gemischt. Die Mischung wird auf eine Papieroberfläche aufgebracht und mit Hilfe eines Bindemittels fixiert. Die Schichtdicke der Kapselteilmischung beträgt 0,1 mm.

Nun wird ein Schreibstift über die Oberfläche der Kapselteile geführt, so daß ein Druck auf die Kapselteilchen ausgeübt wird, wodurch die Hülle der Kapselteilchen an der Stelle an der der Schreibstift geführt wird, zerstört werden. Es entsteht eine Schreibspur aus Polypyrrol, die eine elektrische Leitfähigkeit von 0,1 S/cm hat.

## Beispiel 2

Es wird wie oben gearbeitet, jedoch anstelle von Pyrrol Thiophen verwendet. Hierdurch erhält man eine Schreibspur einer Leitfähigkeit von 0,5 S/cm.

## Beispiel 3

Es wird wie in Beispiel 1 und 2 gearbeitet jedoch anstelle von Eisen-III--Perchlorat, Natriumpersulfat verwendet. Es entsteht eine Schreibspur eine Leitfähigkeit von 0,3 S/cm.

## Patentansprüche

1. Verwendung von Gemischen von Mikrokapseln, deren jeweils eine Sorte im wesentlichen Pyrrol und deren andere Sorte im wesentlichen ein Oxidationsmittel aus der Klasse der Salze von Percxosäuren oder von Perchlorsäure enthält, wobei mindestens eine Sorte ferner ein Leitsalz enthält aus der Gruppe der Salze mit den Anionen $BF_4^-$, $AsF_4^-$, $R-SO_3^-$, $AsF_6^-$, $SbF_6^-$, $SbCl_6^-$, $ClO_4^-$, $HSO_4^-$ und $SO_4^{2-}$ zur

Herstellung von Schaltungsnetzen oder Informationsträgern durch Ausübung von Druck in Form eines Musters oder einer Druckspur auf eine auf einen elektrisch nichtleitenden Werkstoff aufgebrachte Schicht des Gemisches der Mikrokapseln, wobei elektrisch leitfähiges Polypyrrol in der Anordnung des Druckmusters bzw. der Druckspur gebildet wird.

## Claims

1. Use of mixtures of microcapsules of which one kind contains essentially pyrrole and the other kind essentially an oxidizing agent of the class of the salts of peroxoacids or of perchloric acid, at least one kind further containing a conducting salt from the group of the salts with the anions $BF_4^-$, $AsF_4^-$, $R\text{-}SO_3^-$, $AsF_6^-$, $SbF_5^-$, $SbCl_6^-$, $ClO_4^-$, $HSO_4^-$ and $SO_4^{2-}$, for fabricating circuit networks or information carriers by exertion of pressure in the form of a pattern or trace on a layer of the mixture of microcapsules applied to an electrically nonconducting material to form electrically conductive polypyrrole in the arrangement of the pattern or trace.

## Revendications

1. Utilisation de mélanges de microcapsules dont une sorte contient essentiellement du pyrrole et dont l'autre sorte contient essentiellement un agent d'oxydation choisi dans la classe des sels des acides peroxo ou de l'acide perchlorique, une sorte au moins contenant en plus un sel conducteur choisi dans le groupe des sels dont les anions sont $BF_4^-$, $AsF_4^-$, $R\text{-}SO_3^-$, $AsF_6^-$, $SbF_5^-$, $SbCl_6^-$, $ClO_4^-$, $HSO_4^-$ et $SO_4^{2-}$, pour fabriquer des réseaux de connexions ou des supports d'informations en exerçant une pression de manière à former un dessin ou une trace sur une couche du mélange de microcapsules appliquée sur un matériau non conducteur de l'électricité, ce qui engendre du polypyrrole conducteur de l'électricité à l'emplacement du dessin formé par pression ou de la trace formée par pression.